(19)

Europäisches
Patentamt

European
Patent Office

Office européen
des brevets

(11)  **EP 3 524 996 A1**

(12)  **EUROPEAN PATENT APPLICATION**

(43) Date of publication:
  **14.08.2019   Bulletin 2019/33**

(51) Int Cl.:
  *G01R 33/565* (2006.01)   *G01R 33/561* (2006.01)

(21) Application number: **18155725.7**

(22) Date of filing: **08.02.2018**

(84) Designated Contracting States:
  **AL AT BE BG CH CY CZ DE DK EE ES FI FR GB
  GR HR HU IE IS IT LI LT LU LV MC MK MT NL NO
  PL PT RO RS SE SI SK SM TR**
  Designated Extension States:
  **BA ME**
  Designated Validation States:
  **MA MD TN**

(71) Applicant: **Koninklijke Philips N.V.
  5656 AE Eindhoven (NL)**

(72) Inventors:
  • **FUDERER, Miha
    5656 AE Eindhoven (NL)**
  • **DE WEERDT, Elwin
    5656 AE Eindhoven (NL)**
  • **SMINK, Jouke
    5656 AE Eindhoven (NL)**

(74) Representative: **de Haan, Poul Erik et al
  Philips International B.V.
  Philips Intellectual Property & Standards
  High Tech Campus 5
  5656 AE Eindhoven (NL)**

(54)  **REDUCTION OF ARTIFACTS IN PARALLEL MAGNETIC RESONANCE IMAGING**

(57)  The invention provides for a medical imaging system (100, 300) for reducing artifacts in magnetic resonance (MR) images acquired and reconstructed according to parallel MR imaging protocol such as e.g. SENSE or GRAPPA, the artifacts being due to incorrect coil sensitivity data or k-space kernel, e.g. due to breathing motion of the subject during the acquisition of MR data and calibration data, comprising: a memory (110) for storing machine executable instructions; (120) and a processor (104) for controlling the medical imaging system. Execution of the machine executable instructions causes the processor to: receive (200) imaging magnetic resonance data (122) descriptive of a region of interest (309) of a subject (320), wherein the imaging magnetic resonance data is data acquired according to a parallel imaging magnetic resonance imaging protocol; receive (202) multiple sets of coil sensitivity data (124) descriptive of the region of interest of the subject, e.g. from repeated acquisition of the calibration magnetic resonance data of a subject being imaged in a varied of different motion states, such as in various positions of breathing during a free breathing magnetic resonance protocol; reconstruct (204) a set of magnetic resonance images (126), wherein each member of the set of magnetic resonance images is created by reconstructing according to the parallel imaging magnetic resonance imaging protocol a magnetic resonance image using the imaging magnetic resonance data and one of the set of multiple coil sensitivity data; assign (206) a quality rating (128) to each of the set of magnetic resonance images, wherein the quality rating is descriptive of image quality; and choose (208) a selected magnetic resonance image (132) from the set of magnetic resonance images using the quality rating and a predefined criteria.

Fig. 3

EP 3 524 996 A1

**Description**

FIELD OF THE INVENTION

The invention relates to magnetic resonance imaging, in particular to techniques of parallel magnetic resonance imaging.

BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field.

During an MRI scan, Radio Frequency (RF) pulses generated by one or more transmitter coils cause a called B1 field. Additionally applied gradient fields and the B1 field do cause perturbations to the effective local magnetic field. RF signals are then emitted by the nuclear spins and detected by one or more receiver coils. Data can be acquired separately by the individual receiver coils. Images reconstructed from data for each of the individual receiver coils can be combined into a single image or image data using several different techniques. SENSitivity Encoding (SENSE) magnetic resonance imaging and GeneRalized Autocalibrating Partially Parallel Acquisition (GRAPPA) are two such techniques.

United States patent application publication US 2016/0003928 A1 discloses of processing MRI image data to reduce or eliminate motion-related artifacts in MRI images includes: electronically repeatedly acquiring sets of 2D or 3D k-space data of a target region of a subject using at least one MRI pulse sequence; electronically applying a bootstrapping procedure to produce a large number of images from the acquired k-space data; then electronically evaluating the images produced by the bootstrapping procedure; and electronically identifying an image with a minimal motion-related artifact level from the evaluation of the images produced by the boot-strapping procedure.

SUMMARY OF THE INVENTION

The invention provides for a medical imaging system in the independent claims. Embodiments are given in the dependent claims.

Parallel imaging techniques use multiple antenna elements to simultaneously acquire magnetic resonance imaging data. To reconstruct an image from the magnetic resonance data, there should be a way to consistently combine the data. In some techniques like SENSE there are pre-acquired mappings or coil sensitivity data which provides a means for combining the data in image space. Other techniques like GRAPPA acquire a k-space kernel during the actual acquisition and use this to combine the data in k-space. Various occurrences, such as patient motion can make the coil sensitivity data or k-space kernel incorrect. Embodiments of the invention may provide for the improved reconstruction of magnetic resonance images by acquiring calibration magnetic resonance data multiple times. The calibration magnetic resonance data is then used to construct coil sensitivity data or k-space kernels which are used for image reconstruction. The repeated acquisition of the calibration magnetic resonance data may for example capture the subject being imaged in a varied of different motion states, such as in various positions of breathing.

In one aspect, the invention provides for a medical imaging system. A medical imaging system as used herein may encompass a computing device for the processing, displaying or modification of images or it may also include such a computing device plus an apparatus for acquiring medical image data. For example, a medical imaging system may also include a magnetic resonance imaging system.

The medical imaging system comprises a memory for storing machine-executable instructions. The medical imaging system further comprises a processor for controlling the medical imaging system. Execution of the machine-executable instructions causes the processor to receive imaging magnetic resonance data descriptive of a region of interest of a subject. The imaging magnetic resonance data is data acquired according to a parallel imaging magnetic resonance imaging protocol. Execution of the machine-executable instructions further causes the processor to receive multiple sets of coil sensitivity data descriptive of the region of interest of the subject. Execution of the machine-executable instructions further causes the processor to reconstruct a set of magnetic resonance images. Each member of the set of magnetic resonance images is created by reconstructing according to the parallel imaging magnetic resonance imaging protocol a magnetic resonance image using the imaging magnetic resonance data and one of the set of multiple coil sensitivity data.

Execution of the machine-executable instructions further causes the processor to assign a quality rating to each of the set of magnetic resonance images. The quality rating is descriptive of the quality of the respective image. The quality rating may take different forms in different examples and in different embodiments. For example the quality rating may be a ranking in the quality of the set of magnetic resonance images. The assigning of such a ranking could be received for example from a user interface. In other examples various automatic algorithms may be applied to each of the set of the magnetic resonance images and the quality rating could be applied automatically.

Execution of the machine-executable instructions further cause the processor to choose a selected magnetic resonance image from the set of magnetic resonance images using the quality rating. For example the magnetic resonance image with the highest quality rating could be selected. This embodiment may be beneficial because it may provide for a means of automatically providing for a higher quality magnetic resonance image. For example the multiple sets of coil sensitivity data could be acquired when a subject is moving or has some sort of internal motion phase or state. By having the multiple sets of coil sensitivity data they can all be used to reconstruct examples of the magnetic resonance image. The magnetic resonance image which has the best image characteristics according to a predetermined set of criteria may then be selected and used as for example a diagnostic or clinical image. The quality rating could for example be a numerical value. In this case the predetermined criteria could be to select the image with the highest or lowest numerical value. In other examples, the quality rating could be a ranking. In this case the predetermined criteria could be select the lowest or highest ranked image.

In another embodiment, the medical imaging system further comprises a magnetic resonance imaging system. The magnetic resonance imaging system comprises an RF system comprising an imaging coil. The imaging coil comprises multiple antenna elements. These may also be referred to as multiple channels. The radio-frequency system is configured for acquiring the imaging magnetic resonance data and calibration magnetic resonance data from the subject. The memory further contains pulse sequence commands. The pulse sequence commands are configured for acquiring magnetic resonance data according to the parallel imaging magnetic resonance imaging protocol. The pulse sequence commands are further configured for acquiring the calibration magnetic resonance data. The calibration magnetic resonance data is descriptive of coil sensitivities of the multiple antenna elements.

Execution of the machine-executable instructions further cause the processor to control the magnetic resonance imaging system with the pulse sequence commands to repeatedly acquire the calibration magnetic resonance data. Execution of the machine-executable instructions further cause the processor to control the magnetic resonance imaging system with the pulse sequence commands to acquire the imaging magnetic resonance data. Execution of the machine-executable instructions further cause the processor to reconstruct the multiple sets of coil sensitivity data from the repeatedly acquired calibration magnetic resonance data. This embodiment may be beneficial because the repeated acquisition of the calibration magnetic resonance data may enable the construction of magnetic resonance images that better match the motion state of a subject.

In another embodiment, the magnetic resonance imaging system further comprises a motion sensor configured for measuring motion data descriptive of a motion of the subject. Execution of the machine-executable instructions further cause the processor to trigger repeated acquisition of the calibration magnetic resonance data using the motion data. This may for example include the acquisition of the calibration magnetic resonance data or additional acquisition of it when motion of the subject is detected. In other examples the motion data may also be descriptive of a particular phase or position of the subject during motion. The motion data could then be there to trigger when at least partially the calibration magnetic resonance data is acquired. This may be useful in ensuring that there is calibration magnetic resonance data descriptive of all motion phases of the subject which are relevant or interesting.

In another embodiment, the motion sensor is any one of the following: a respiratory monitor, a chest expansion belt, a magnetic resonance navigator, an EEG signal, a camera, a fiducial marker that might be for example either optical or an MRI fiducial marker, and combinations thereof.

In another embodiment, the multiple acquisitions of the calibration magnetic resonance data are performed according to any one of the following: at least partially before acquisition of the imaging magnetic resonance data, at least partially after acquisition of the imaging magnetic resonance data, and combinations thereof. This may be beneficial because there may be a larger pool of calibration magnetic resonance data available. Also the position of the subject may shift over time. In this case it may be beneficial to then reacquire after the acquisition of the imaging magnetic resonance data.

In another embodiment, execution of the machine-executable instructions further cause the processor to reject the multiple sets of coil sensitivity data if the quality rating of each of the set of magnetic resonance images meets a predetermined criteria. For example if all of the images of the set of magnetic resonance images have folding in them or gross errors, or serious artifacts then the multiple sets of coil sensitivity data could be rejected. Execution of the machine-executable instructions further cause the processor to control the magnetic resonance imaging system with the pulse sequence commands to acquire replacement calibration magnetic resonance data at least one time. This may be beneficial because if the subject has moved and all of the sets of coil sensitivity data are corrupted or incorrect this may provide for a further means of using the imaging magnetic resonance data. Execution of the machine-executable instructions further causes the processor to reconstruct at least one set of replacement coil sensitivity data from the replacement calibration magnetic resonance data.

Execution of the machine-executable instructions further cause the processor to reconstruct the magnetic resonance image according to the parallel imaging magnetic resonance imaging protocol using the imaging magnetic resonance data and a set of replacement coil sensitivity data selected from the at least one set of replacement coil sensitivity data. This embodiment may be beneficial because it may provide a means for preventing image artifacts if the coil sensitivity data is no longer valid.

In another embodiment, the quality rating is assigned to each of the set of magnetic resonance images by calculating a sparsity transform of each of the set of magnetic resonance images.

In another embodiment, the quality rating is assigned to each of the set of magnetic resonance images by calculating an entropy value from the sparsity transform of each of the set of magnetic resonance images. The quality rating comprises the entropy value.

In another embodiment, the quality rating comprises a user ranking received from a user interface. This may be beneficial because it may provide for a means of classifying the images.

In another embodiment, the quality rating comprises a machine-generated ranking received from a trained pattern recognition system. This may provide for an automated means of assigning the quality rating.

The trained pattern recognition system may for example be a neural net or machine learning system. The training of the neural net or the machine learning system could for example be performed by the previous embodiment where a user ranking was received from a user interface. The input from the user interface may for example be used for training the neural net or the machine learning system.

In another embodiment, execution of the machine-executable instructions further cause the processor to store the selected magnetic resonance image in the memory or a database.

In another embodiment, execution of the machine-executable instructions further cause the processor to display the selected magnetic resonance image on a display.

In another embodiment, the parallel imaging magnetic resonance imaging protocol is a SENSE magnetic resonance imaging protocol, a SPIRIT magnetic resonance imaging protocol, and an E-SPIRIT magnetic resonance imaging protocol.

In another aspect, the invention provides for a method of operating the medical imaging system. The method comprises receiving imaging magnetic resonance data descriptive of a region of interest of the subject. The method further comprises the imaging magnetic resonance data being acquired according to a parallel imaging magnetic resonance imaging protocol. The method further comprises receiving multiple sets of coil sensitivity data descriptive of the region of interest of the subject. The method further comprises reconstructing a set of magnetic resonance images. Each member of the set of magnetic resonance images is created and reconstructed according to the parallel imaging magnetic resonance imaging protocol and the magnetic resonance imaging data using the imaging magnetic resonance data and one of the set of multiple coil sensitivity data. The method further comprises assigning a quality rating to each of the set of magnetic resonance images. The quality rating is descriptive of the quality of the respective image. The method further comprises choosing a selected magnetic resonance image from the set of magnetic resonance images using the quality rating.

In another embodiment, the medical imaging system comprises a magnetic resonance imaging system. The magnetic resonance imaging system comprises an RF system comprising an imaging coil. The imaging coil comprises multiple antenna elements. The RF system is configured for acquiring the imaging magnetic resonance data and the calibration magnetic resonance data from the subject. The method further comprises controlling the magnetic resonance imaging system with the pulse sequence commands to repeatedly acquire the calibration magnetic resonance data from a subject in different motion states. The pulse sequence commands are configured for acquiring the imaging magnetic resonance data according to the parallel imaging magnetic resonance imaging protocol. The pulse sequence commands are further configured for acquiring calibration magnetic resonance data descriptive of coil sensitivities of the multiple antenna elements.

The method further comprises controlling the magnetic resonance imaging system with the pulse sequence commands to acquire the imaging magnetic resonance data. The method further comprises reconstructing the multiple sets of coil sensitivity data from the repeatedly acquired calibration magnetic resonance data. The above embodiment may for example be useful when a subject of an MRI examination is breathing freely.

In another aspect, the invention provides for a computer program product comprising machine-executable instructions for execution by a processor configured for controlling a medical imaging system. Execution of the machine-executable instructions further cause the processor to receive imaging magnetic resonance data descriptive of a region of interest of a subject. The imaging magnetic resonance data is acquired according to a parallel imaging magnetic resonance imaging protocol. Execution of the machine-executable instructions further cause the processor to receive multiple sets of coil sensitivity data descriptive of the region of interest of the subject.

Execution of the machine-executable instructions further cause the processor to reconstruct a set of magnetic resonance images. Each member of the set of magnetic resonance images is created by reconstructing according to the parallel imaging magnetic resonance imaging protocol a magnetic resonance image using the imaging magnetic resonance data. Execution of the machine-executable instructions further cause the processor to assign a quality rating to each of the set of magnetic resonance images. The quality rating is dependent on the quality of the respective image. Execution of the machine-executable instructions further cause the processor to choose a selected magnetic resonance image from the set of magnetic resonance images using the quality rating.

In another aspect, the invention provides for a medical imaging system. The medical imaging system comprises a memory for storing machine-executable instructions. The medical imaging system further comprises a processor for controlling the medical imaging system. Execution of the machine-executable instructions further causes the processor to receive imaging magnetic resonance data descriptive of a region of interest of a subject. The imaging magnetic resonance data is data acquired according to a parallel imaging magnetic resonance imaging protocol. Execution of the machine-executable instructions further cause the processor to receive multiple sets of coil sensitivity data descriptive of the region of interest of the subject.

Execution of the machine-executable instructions further cause the processor to assign a quality rating to each of the multiple sets of coil sensitivity data. Execution of the machine-executable instructions further causes the processor to choose a selected set of coil sensitivity data using the quality rating. Execution of the machine-executable instructions further cause the processor to reconstruct a selected magnetic resonance image using the selected set of coil sensitivity data and the imaging magnetic resonance data. This embodiment may be beneficial because the set of coil sensitivity data which may result in the best magnetic resonance image is selected without reconstructing all of the images for each of the set of coil sensitivity data. This may result in a reduction of the amount of time necessary to reconstruct the selected magnetic resonance image.

The assigning of the quality rating due to each of the multiple sets of coil sensitivity data using the imaging magnetic resonance data may be performed in different ways in different embodiments. For example in one case intermediate images may be reconstructed which are then compared to the imaging magnetic resonance data. For example the imaging magnetic resonance data could be reconstructed into an image making assumptions about the coil sensitivities. This may then be used to provide for a rough image which can then be compared to images reconstructed from the coil sensitivity data to estimate how well a particular set of coil sensitivity data matches the rough image. This process can be repeated for each of the sets of coil sensitivity data so that a chosen set of coil sensitivity data which best fits the rough image is selected.

In the above embodiment, the comparison of the rough image with one or more images or a composite image generated from a set of coil sensitivity data may provide a means of estimating how closely the movement state or position of the subject at the time the imaging magnetic resonance data was acquired matches the corresponding movement state or phase of the different sets of coil sensitivity data.

In another embodiment, the medical imaging system further comprises a magnetic resonance imaging system. The magnetic resonance imaging system comprises an RF system comprising an imaging coil. The imaging coil comprises multiple antenna elements. The RF system is configured for acquiring the imaging magnetic resonance data and the calibration magnetic resonance data from the subject. The memory further contains pulse sequence commands. The pulse sequence commands are configured for acquiring the imaging magnetic resonance data according to the parallel imaging magnetic resonance imaging protocol. The pulse sequence commands are further configured for acquiring the calibration magnetic resonance data descriptive of coil sensitivities of the multiple antenna elements.

Execution of the machine-executable instructions further cause the processor to control the magnetic resonance imaging system with the pulse sequence commands to repeatedly acquire the calibration magnetic resonance data. Execution of the machine-executable instructions further cause the processor to control the magnetic resonance imaging system with the pulse sequence commands to acquire the imaging magnetic resonance data. Execution of the machine-executable instructions further cause the processor to reconstruct the multiple sets of coil sensitivity data from the repeatedly acquired calibration magnetic resonance data.

In another embodiment, the imaging magnetic resonance data comprises measured coil data measured by multiple antenna elements. The quality rating is assigned to each of the set of the magnetic resonance images by calculating estimated coil data for each of the multiple antenna elements and calculating a residual between the estimated coil data and the measured coil data of each of the multiple antenna elements. The quality rating comprises a residual between the estimated coil data and the measured coil data for each of the multiple antenna elements. The coil sensitivity data may comprise data in k-space which may be reconstructed into images or used in k-space which can be compared to the estimated coil data. If done in image space this can for example be done by using a metric to compare two images. If done in k-space the various values in k-space may also be compared numerically.

In another embodiment, the residual is calculated in k-space.

In another embodiment, the residual is calculated in the image space.

In another embodiment execution of the machine-executable instructions further cause the processor to store the selected magnetic resonance image in the memory or a database.

In another embodiment, execution of the machine-executable instructions further cause the processor to display the selected magnetic resonance image on a display.

In another embodiment, the parallel imaging magnetic resonance imaging protocol is any one of the following: a SENSE magnetic resonance imaging protocol, a SPIRIT magnetic resonance imaging protocol, and an E-SPIRIT magnetic resonance imaging protocol.

In another aspect, the invention provides for a method of operating the medical imaging system. The method comprises receiving imaging magnetic resonance data descriptive of a region of interest of the subject. The imaging magnetic resonance data is acquired according to a parallel imaging magnetic resonance imaging protocol. The method further comprises receiving multiple sets of coil sensitivity data descriptive of the region of interest of the subject. The method further comprises assigning a quality rating to each of the multiple sets of coil sensitivity data. The method further comprises choosing a selected set of coil sensitivity data using the quality rating. The method further comprises reconstructing a selected magnetic resonance image using the selected set of coil sensitivity data and the imaging magnetic resonance data.

In another embodiment, the medical imaging system further comprises a magnetic resonance imaging system. The magnetic resonance imaging system comprises an RF system comprising an imaging coil. The imaging coil comprises multiple antenna elements. The RF system is configured for acquiring the imaging magnetic resonance data and calibration magnetic resonance data from the subject. The method further comprises controlling the magnetic resonance imaging system with the pulse sequence commands to repeatedly acquire the calibration magnetic resonance data from a subject in different motion states. The pulse sequence commands are configured for acquiring the imaging magnetic resonance data according to the parallel imaging magnetic resonance imaging protocol. The pulse sequence commands are further configured for acquiring the calibration magnetic resonance data descriptive of coil sensitivities of the multiple antenna elements. The method further comprises controlling the magnetic resonance imaging system with the pulse sequence commands to acquire the imaging magnetic resonance data. The method further comprises reconstructing the multiple sets of coil sensitivity data from the repeatedly acquired calibration magnetic resonance data.

This embodiment may be particularly applicable to compensating for different motion states when the subject is in a so called free breathing state during the acquisition of the imaging magnetic resonance data.

In another aspect, the invention provides for a computer program product comprising machine-executable instructions for execution by a processor controlling the medical imaging system. Execution of the machine-executable instructions causes the processor to receive imaging magnetic resonance data descriptive of a region of interest of a subject. The imaging magnetic resonance data is data acquired according to a parallel imaging magnetic resonance imaging protocol. Execution of the machine-executable instructions further cause the processor to receiving multiple sets of coil sensitivity data descriptive of the region of interest of the subject.

Execution of the machine-executable instructions further cause the processor to assign a quality rating to each of the multiple sets of coil sensitivity data. Execution of the machine-executable instructions further cause the processor to choose a selected set of coil sensitivity data using the quality rating. Execution of the machine-executable instructions further cause the processor to reconstruct a selected magnetic resonance image using the selected set of coil sensitivity data and the imaging magnetic resonance data.

In another aspect, the invention provides for a medical imaging system that comprises a memory for storing machine-executable instructions and a processor for controlling the medical imaging system. Execution of the machine-executable instructions further cause the processor to receive imaging magnetic resonance data descriptive of a region of interest of a subject. The imaging magnetic resonance data is data acquired according to a parallel imaging magnetic resonance imaging protocol. Execution of the machine-executable instructions further cause the processor to receive multiple GRAPPA kernels descriptive of the subject. A GRAPPA kernel as used herein encompasses a set of reconstruction weights or weighting factors that are used to combine magnetic resonance data in k-space for a parallel imaging magnetic resonance imaging protocol.

Execution of the machine-executable instructions further cause the processor to calculate reconstructed k-space data for each one of the multiple GRAPPA kernels using the imaging magnetic resonance data and one of the multiple GRAPPA kernels. Execution of the machine-executable instructions further cause the processor to assign a residual to each of the multiple GRAPPA kernels by calculating a residual between the reconstructed k-space data and the imaging magnetic resonance data in k-space. Execution of the machine-executable instructions further cause the processor to choose a selected GRAPPA kernel from the set of magnetic resonance images using the residual. The residual may also be referred to as a quality rating herein.

Execution of the machine-executable instructions further cause the processor to reconstruct a selected magnetic resonance image using the selected GRAPPA kernel and the imaging magnetic resonance data. This embodiment may be beneficial because it may provide for an efficient means of compensating for motion of the subject without prior tracking of the motion of the subject.

This embodiment may be implemented in a variety of different ways. For example the multiple GRAPPA kernels could be acquired independently or separately. In other instances the GRAPPA kernels could be taken from other images or during the acquisition of other images of the same subject within the magnetic resonance imaging system. The imaging magnetic resonance data could for example also be acquired using a GRAPPA magnetic resonance imaging protocol. The multiple GRAPPA kernels could then be used to replace the acquired GRAPPA kernel in case they have a better matching to the motion state of the subject. In other instances the parallel imaging magnetic resonance imaging protocol could be a more conventional or image space-based parallel magnetic resonance imaging protocol. The GRAPPA kernel could be used in place of a set of coil sensitivity data.

In another embodiment, the medical imaging system further comprises a magnetic resonance imaging system. The magnetic resonance imaging system comprises an RF system comprising an imaging coil. The imaging coil comprises multiple antenna elements. The RF system is configured for acquiring the imaging magnetic resonance data and calibration magnetic resonance data from the subject. The memory further contains pulse sequence commands. The pulse sequence commands are configured for acquiring the imaging magnetic resonance data according to the parallel imaging magnetic resonance imaging protocol. The pulse sequence commands are further configured for acquiring the calibration magnetic resonance data descriptive of GRAPPA kernels of the multiple antenna elements. Execution of the machine-executable instructions further cause the processor to control the magnetic resonance imaging system with the pulse sequence commands to repeatedly acquire the calibration magnetic resonance data. Execution of the machine-executable instructions further cause the processor to control the magnetic resonance imaging system with the pulse sequence commands to acquire the imaging magnetic resonance data. Execution of the machine-executable instructions further cause the processor to reconstruct the multiple GRAPPA kernels from the repeatedly acquired calibration magnetic resonance data.

In the above embodiment, it may be that each element of the GRAPPA kernels is representative of the subject at a particular time interval. This may mean that each of the multiple GRAPPA kernels may represent an independent or separate motion state of the subject.

In another embodiment, the magnetic resonance imaging system further comprises a motion sensor configured for measuring motion data descriptive of a motion of the subject. Execution of the machine-executable instructions further causes the processor to trigger repeated acquisition of the calibration magnetic resonance data using the motion data. This for example may be beneficial in triggering the magnetic resonance imaging system to automatically acquire the calibration magnetic resonance data.

In another embodiment, the multiple acquisitions of the calibration magnetic resonance data are performed at least partially before acquisition of the imaging magnetic resonance data.

In another embodiment, the multiple acquisitions of the calibration magnetic resonance data are performed at least partially after acquisition of the imaging magnetic resonance data.

In another embodiment, the multiple acquisitions of the calibration magnetic resonance data are performed during acquisition of the imaging magnetic resonance data. For example the magnetic resonance protocol used to acquire the imaging magnetic resonance data maybe done using a GRAPPA protocol. This may provide an additional GRAPPA kernel to use.

In another embodiment, execution of the machine-executable instructions further cause the processor to store the selected magnetic resonance image in the memory or a database.

In another embodiment, execution of the machine-executable instructions further cause the processor to display the selected magnetic resonance image on a display or display device.

In another embodiment, the parallel imaging magnetic resonance imaging protocol is a GRAPPA magnetic resonance imaging protocol.

In another aspect, the invention provides for a method of operating a medical imaging system. The method comprises receiving imaging magnetic resonance data descriptive of a region of interest of a subject. The imaging magnetic resonance data is data acquired according to a parallel imaging magnetic resonance imaging protocol. The method further comprises receiving multiple GRAPPA kernels descriptive of the subject. The method further comprises calculating reconstructed k-space data using the imaging magnetic resonance data and the one of the multiple GRAPPA kernels. The method further comprises assigning a residual to each of the multiple GRAPPA kernels by calculating a residual between the reconstructed k-space data and the imaging magnetic resonance data in k-space. The method further comprises choosing a selected GRAPPA kernel from the set of magnetic resonance images using the residual. The method further comprises reconstructing a selected image using the selected GRAPPA kernel and the imaging magnetic resonance data.

In another embodiment, the medical imaging system further comprises a magnetic resonance imaging system. The magnetic resonance imaging system comprises an RF system comprising an imaging coil. The imaging coil comprises multiple antenna elements. The radio-frequency system is configured for acquiring the imaging magnetic resonance data and calibration magnetic resonance data from the subject. The method further comprises controlling the magnetic resonance imaging system with the pulse sequence commands to repeatedly acquire the calibration magnetic resonance data from a subject in different motion states. The pulse sequence commands are configured for acquiring the imaging magnetic resonance data according to the parallel imaging magnetic resonance imaging protocol. The pulse sequence commands are further configured for acquiring calibration magnetic resonance data descriptive of GRAPPA kernels of the multiple antenna elements. The method further comprises controlling the magnetic resonance imaging system with the pulse sequence commands to acquire the imaging magnetic resonance data. The method further comprises reconstructing multiple GRAPPA kernels from the repeatedly acquired calibration magnetic resonance data.

In another embodiment, the repeated acquisition of the calibration magnetic resonance data from the subject in different motion states is performed such that different motion states are different breathing states or chest motion states of the subject. For example this could be performed during a so called free breathing magnetic resonance protocol where the subject is not required to make a breath hold during imaging.

In another aspect, the invention provides for a computer program product comprising machine-executable instructions for execution by a processor controlling the magnetic resonance imaging system. Execution of the machine-executable instructions causes the processor to receive imaging magnetic resonance data descriptive of a region of interest of a subject. The imaging magnetic resonance data is data acquired according to a parallel imaging magnetic resonance imaging protocol. Execution of the machine-executable instructions further cause the processor to receive multiple GRAPPA kernels descriptive of the subject. Execution of the machine-executable instructions further cause the processor to calculate reconstructed k-space data for each one of the multiple GRAPPA kernels using the imagining magnetic resonance data and the one of the multiple GRAPPA kernels. Execution of the machine-executable instructions further cause the processor to assign a residual to each of the multiple GRAPPA kernels by calculating a residual between the reconstructed k-space data and the imaging magnetic resonance data in k-space. Execution of the machine-executable instructions further causes the processor to choose a selected GRAPPA kernel from the set of magnetic resonance images using the residual. Execution of the machine-executable instructions further cause the processor to reconstruct a selected magnetic resonance image using the selected GRAPPA kernel and the imaging magnetic resonance data.

It is understood that one or more of the aforementioned embodiments of the invention may be combined as long as the combined embodiments are not mutually exclusive.

Various embodiments may possibly be described by one or more of the following features specified in the following numbered clauses:

1. A medical imaging system, comprising:

- a memory for storing machine executable instructions; and
- a processor for controlling the medical imaging system, wherein execution of the machine executable instructions causes the processor to:
- receive imaging magnetic resonance data descriptive of a region of interest of a subject, wherein the imaging magnetic resonance data is data acquired according to a parallel imaging magnetic resonance imaging protocol;
- receive multiple sets of coil sensitivity data descriptive of the region of interest of the subject;
- reconstruct a set of magnetic resonance images, wherein each member of the set of magnetic resonance images is created by reconstructing according to the parallel imaging magnetic resonance imaging protocol a magnetic resonance image using the imaging magnetic resonance data and one of the set of multiple coil sensitivity data;
- assign a quality rating to each of the set of magnetic resonance images, wherein the quality rating is descriptive of image quality; and
- choose a selected magnetic resonance image from the set of magnetic resonance images using the quality rating using a predefined criteria.

2. The medical imaging system of clause 1, wherein the medical imaging system further comprises a magnetic resonance imaging system, wherein the magnetic resonance imaging system comprises an RF system comprising an imaging coil, wherein the imaging coil comprises multiple antenna elements, wherein the RF system is configured for acquiring the imaging magnetic resonance data and calibration magnetic resonance data from the subject, wherein the memory further contains pulse sequence commands, wherein the pulse sequence commands are configured for acquiring the imaging magnetic resonance data according to the parallel imaging magnetic resonance imaging protocol; wherein the pulse sequence commands are further configured for acquiring the calibration magnetic resonance data descriptive of coil sensitivities of the multiple antenna elements, wherein execution of the machine executable instructions further cause the processor to:

- control the magnetic resonance imaging system with the pulse sequence commands to repeatedly acquire the calibration magnetic resonance data;
- control the magnetic resonance imaging system with the pulse sequence commands to acquire the imaging magnetic resonance data; and
- reconstruct the multiple sets of coil sensitivity data from the repeatedly acquired calibration magnetic resonance data.

3. The medical imaging system of clause 2, wherein the magnetic resonance imaging system further comprises a motion sensor configured for measuring motion data descriptive of a motion of the subject, wherein execution of the machine executable instructions further causes the processor to trigger repeated acquisition of the calibration magnetic resonance data using the motion data.

4. The medical imaging system of clause 2 or 3, wherein the multiple acquisitions of the calibration magnetic resonance data are performed according to any one of the following:

- at least partially before acquisition of the imaging magnetic resonance data;

- at least partially after acquisition of the imaging magnetic resonance data; and
- combinations thereof.

5. The medical imaging system of clause 2, 3, or 4, wherein execution of the machine executable instructions further causes the processor to:

- reject the multiple sets of coil sensitivity data if the quality rating of each of the set of magnetic resonance images meets a predetermined criteria;
- control the magnetic resonance imaging system with the pulse sequence commands to acquire replacement calibration magnetic resonance data at least one time;
- reconstruct at least one of the set of replacement coil sensitivity data from the replacement calibration magnetic resonance data; and
- reconstruct the magnetic resonance image according to the parallel imaging magnetic resonance imaging protocol using the imaging magnetic resonance data and a set of replacement coil sensitivity data selected from the at least one set of replacement coil sensitivity data.

6. The medical imaging system of any one of the preceding clauses, wherein
the quality rating is assigned to each of the set of magnetic resonance images by:

- calculating a sparsity transform of each of set of magnetic resonance images; and
- calculate an entropy value from the sparsity transform of each of the set of magnetic resonance images, wherein the quality rating comprises the entropy value.

7. The medical imaging system of any one of the preceding clauses, wherein the quality rating comprises a user ranking received from a user interface.

8. The medical imaging system of any one of the preceding clauses, wherein the quality rating comprises a machine generated ranking received from a trained pattern recognition system.

9. The medical imaging system of any one of the preceding clauses, wherein execution of the machine executable instructions further causes the processor to:

- store the selected magnetic resonance image in the memory or a database;
- display the selected magnetic resonance image on a display; and
- combinations thereof.

10. The medical imaging system of any one of the preceding clauses, wherein the parallel imaging magnetic resonance imaging protocol is a SENSE magnetic resonance imaging protocol, a SPIRIT magnetic resonance imaging protocol, an E-SPIRIT magnetic resonance imaging protocol.

11. A method of operating a medical imaging system, wherein the method comprises:

- receiving imaging magnetic resonance data descriptive of a region of interest of a subject, wherein the imaging magnetic resonance data is data acquired according to a parallel imaging magnetic resonance imaging protocol;
- receiving multiple sets of coil sensitivity data descriptive of the region of interest of the subject;
- reconstructing a set of magnetic resonance images, wherein each member of the set of magnetic resonance images is created by reconstructing according to the parallel imaging magnetic resonance imaging protocol a magnetic resonance image using the imaging magnetic resonance data and one of the set of multiple coil sensitivity data;
- assigning a quality rating to each of the set of magnetic resonance images, wherein the quality rating is descriptive of the quality of the respective image; and
- choosing a selected magnetic resonance image from the set of magnetic resonance images using the quality rating and a predefined criteria.

12. The method of clause 11, wherein the medical imaging system comprises a magnetic resonance imaging system, wherein the magnetic resonance imaging system comprises an RF system comprising an imaging coil, wherein the imaging coil comprises multiple antenna elements, wherein the RF system is configured for acquiring the imaging magnetic resonance data and calibration magnetic resonance data from the subject, wherein the method further comprises:

- controlling the magnetic resonance imaging system with the pulse sequence commands to repeatedly acquire the calibration magnetic resonance data from a subject in different motion states, wherein the pulse sequence commands are configured for acquiring the imaging magnetic resonance data according to the parallel imaging magnetic resonance imaging protocol; wherein the pulse sequence commands are further configured for acquiring calibration magnetic resonance data descriptive of coil sensitivities of the multiple antenna elements;
- controlling the magnetic resonance imaging system with the pulse sequence commands to acquire the imaging magnetic resonance data; and
- reconstructing the multiple sets of coil sensitivity data from the repeatedly acquired calibration magnetic resonance data.

13. A computer program product comprising machine executable instructions for execution by a processor configured for controlling a medical imaging system, wherein execution of the machine executable instructions causes the processor to:

- receive imaging magnetic resonance data descriptive of a region of interest of a subject, wherein the imaging magnetic resonance data is data acquired according to a parallel imaging magnetic resonance imaging protocol;
- receive multiple sets of coil sensitivity data descriptive of the region of interest of the subject;
- reconstruct a set of magnetic resonance images, wherein each member of the set of magnetic resonance images is created by reconstructing according to the parallel imaging magnetic resonance imaging protocol a magnetic resonance image using the imaging magnetic resonance data and one of the set of multiple coil sensitivity data;
- assign a quality rating to each of the set of magnetic resonance images, wherein the quality rating is descriptive of the quality of the respective image; and
- choose a selected magnetic resonance image from the set of magnetic resonance images using the quality rating and a predefined criteria.

Various embodiments may possibly be described by one or more of the following features specified in the further following numbered clauses:

1 A medical imaging system, comprising:

- a memory for storing machine executable instructions; and
- a processor for controlling the medical imaging system, wherein execution of the machine executable instructions causes the processor to:

    - receive (500) imaging magnetic resonance data descriptive of a region of interest of a subject, wherein the imaging magnetic resonance data is data acquired according to a parallel imaging magnetic resonance imaging protocol;
    - receive (502) multiple sets of coil sensitivity data descriptive of the region of interest of the subject;
    - assigning (504) a quality rating to each of the multiple sets of coil sensitivity data;
    - choose (506) a selected set of coil sensitivity data using the quality rating and a predefined criteria; and
    - reconstruct (508) a selected magnetic resonance image using the selected set of coil sensitivity data and the imaging magnetic resonance data and.

2. The medical imaging system of clause 1, wherein the medical imaging system further comprises a magnetic resonance imaging system, wherein the magnetic resonance imaging system comprises an RF system comprising an imaging coil, wherein the imaging coil comprises multiple antenna elements, wherein the RF system is configured for acquiring the imaging magnetic resonance data and calibration magnetic resonance data from the subject, wherein the memory further contains pulse sequence commands, wherein the pulse sequence commands are configured for acquiring the imaging magnetic resonance data according to the parallel imaging magnetic resonance imaging protocol; wherein the pulse sequence commands are further configured for acquiring calibration magnetic resonance data descriptive of coil sensitivities of the multiple antenna elements, wherein execution of the machine executable instructions further cause the processor to:

- control the magnetic resonance imaging system with the pulse sequence commands to repeatedly acquire the calibration magnetic resonance data;
- control the magnetic resonance imaging system with the pulse sequence commands to acquire the imaging magnetic resonance data; and
- reconstruct the multiple sets of coil sensitivity data from the repeatedly acquired calibration magnetic resonance data.

3. The medical imaging system of clause 1 or 2, wherein the magnetic resonance data comprises measured coil data measured by multiple antenna elements, wherein the quality rating is assigned to each of the set of magnetic resonance images by:

- calculating estimated coil data for each of the multiple antenna elements; and
- calculate a residual between the estimated coil data and the measured coil data of each of the multiple antenna elements, wherein the quality rating comprises the residual between the estimated coil data and the measured coil data of each of the multiple antenna elements.

4. The medical imaging system of clause 3, wherein the residual is calculate in k-space.

5. The medical imaging system of clause 3, wherein the residual is calculated in image space.

6. The medical imaging system of any one of the preceding clauses, wherein execution of the machine executable instructions further causes the processor to:

- store the selected magnetic resonance image in the memory or a database;
- display the selected magnetic resonance image on a display; and
- combinations thereof.

7. The medical imaging system of any one of the preceding clauses, wherein the parallel imaging magnetic resonance imaging protocol is any one of the following: a SENSE magnetic resonance imaging protocol, a SPIRIT magnetic resonance imaging protocol, an E-SPIRIT magnetic resonance imaging protocol.

8. A method of operating a medical imaging system, wherein the method comprises:

- receiving imaging magnetic resonance data descriptive of a region of interest of a subject, wherein the imaging magnetic resonance data is data acquired according to a parallel imaging magnetic resonance imaging protocol;
- receiving multiple sets of coil sensitivity data descriptive of the region of interest of the subject;
- assigning a quality rating to each of the multiple sets of coil sensitivity data;
- choosing a selected set of coil sensitivity data using the quality rating and a predefined criteria; and
- reconstructing a selected magnetic resonance image using the selected set of coil sensitivity data and the imaging magnetic resonance data.

9. The method of clause 8, wherein the medical imaging system further comprises a magnetic resonance imaging system, wherein the magnetic resonance imaging system comprises an RF system comprising an imaging coil, wherein the imaging coil comprises multiple antenna elements, wherein the RF system is configured for acquiring the imaging magnetic resonance data and calibration magnetic resonance data from the subject, wherein the method further comprises:

- controlling the magnetic resonance imaging system with the pulse sequence commands to repeatedly acquire the calibration magnetic resonance data from a subject in different motion states, wherein the pulse sequence commands are configured for acquiring the imaging magnetic resonance data according to the parallel imaging magnetic resonance imaging protocol, wherein the pulse sequence commands are further configured for acquiring calibration magnetic resonance data descriptive of coil sensitivities of the multiple antenna elements;
- controlling the magnetic resonance imaging system with the pulse sequence commands to acquire the imaging magnetic resonance data; and
- reconstructing the multiple sets of coil sensitivity data from the repeatedly acquired calibration magnetic resonance data.

10. A computer program product comprising machine executable instructions for execution by a processor controlling a medical imaging system, wherein execution of the machine executable instructions causes the processor to:

- receive imaging magnetic resonance data descriptive of a region of interest of a subject, wherein the imaging magnetic resonance data is data acquired according to a parallel imaging magnetic resonance imaging protocol;
- receive multiple sets of coil sensitivity data descriptive of the region of interest of the subject;
- assign a quality rating to each of the multiple sets of coil sensitivity data;
- choose a selected set of coil sensitivity data using the quality rating and a predefined criteria; and
- reconstruct a selected magnetic resonance image using the selected set of coil sensitivity data and the imaging magnetic resonance data.

Various embodiments may possibly be described by one or more of the following features specified in the further following numbered clauses:

1. A medical imaging system, comprising:

- a memory for storing machine executable instructions; and
- a processor for controlling the medical imaging system, wherein execution of the machine executable instructions causes the processor to:

  - receive (800) imaging magnetic resonance data descriptive of a region of interest of a subject, wherein the imaging magnetic resonance data is data acquired according to a parallel imaging magnetic resonance imaging protocol;
  - receive (802) multiple GRAPPA kernels descriptive of the subject;
  - calculate (804) reconstructed k-space data for each one of the multiple GRAPPA kernels using the imaging magnetic resonance data and the one of the multiple GRAPPA kernels;
- assign (806) a residual to each of the multiple GRAPPA kernels by calculating a residual between the reconstructed k-space data and the imaging magnetic resonance data in k-space;
- choose (808) a selected GRAPPA kernel from the set of magnetic resonance images using the residual according to a a predefined criteria; and
- reconstruct (810) a selected magnetic resonance image using the selected GRAPPA kernel and the imaging magnetic resonance data.

2. The medical imaging system of clause 1, wherein the medical imaging system further comprises a magnetic resonance imaging system, wherein the magnetic resonance imaging system comprises an RF system comprising an imaging coil, wherein the imaging coil comprises multiple antenna elements, wherein the RF system is configured for acquiring the imaging magnetic resonance data and calibration magnetic resonance data from the subject, wherein the memory further contains pulse sequence commands, wherein the pulse sequence commands are configured for acquiring the imaging magnetic resonance data according to the parallel imaging magnetic resonance imaging protocol; wherein the pulse sequence commands are further configured for acquiring calibration magnetic resonance data descriptive GRAPPA kernels of the multiple antenna elements, wherein execution of the machine executable instructions further cause the processor to:

- control the magnetic resonance imaging system with the pulse sequence commands to repeatedly acquire the calibration magnetic resonance data;
- control the magnetic resonance imaging system with the pulse sequence commands to acquire the imaging magnetic resonance data; and
- reconstruct multiple GRAPPA kernels from the repeatedly acquired calibration magnetic resonance data.

3. The medical imaging system of clause 2, wherein the magnetic resonance imaging system further comprises a motion sensor configured for measuring motion data descriptive of a motion of the subject, wherein execution of the machine executable instructions further causes the processor to trigger repeated acquisition of the calibration magnetic resonance data using the motion data.

4. The medical imaging system of clause 2 or 3, wherein the multiple acquisitions of the calibration magnetic resonance data are performed according to any one of the following:

- at least partially before acquisition of the imaging magnetic resonance data;
- at least partially after acquisition of the imaging magnetic resonance data;
- during acquisition of the imaging magnetic resonance data; and
- combinations thereof.

5. The medical imaging system of clause 4, wherein execution of the machine executable instructions further causes the processor to:

- store the selected magnetic resonance image image in the memory or a database;
- display the selected magnetic resonance image on a display; and
- combinations thereof.

7. The medical imaging system of any one of the preceding clauses, wherein the parallel imaging magnetic resonance imaging protocol is a GRAPPA magnetic resonance imaging protocol.

8. A method of operating a medical imaging system, wherein the method comprises:

- receiving imaging magnetic resonance data descriptive of a region of interest of a subject, wherein the imaging magnetic resonance data is data acquired according to a parallel imaging magnetic resonance imaging protocol;
- receiving multiple GRAPPA kernels descriptive of the subject;
- calculating reconstructed k-space data for each one of the multiple GRAPPA kernels using the imaging magnetic resonance data and the one of the multiple GRAPPA kernels;
- assigning a residual to each of the multiple GRAPPA kernels by calculating a residual between the reconstructed k-space data and the imaging magnetic resonance data in k-space;
- choosing a selected GRAPPA kernel from the set of magnetic resonance images using the residual according to a predefined criteria; and
- reconstructing a selected magnetic resonance image using the selected GRAPPA kernel and the imaging magnetic resonance data.

9. The method of clause 8, wherein the medical imaging system further comprises a magnetic resonance imaging system, wherein the magnetic resonance imaging system comprises an RF system comprising an imaging coil, wherein the imaging coil comprises multiple antenna elements, wherein the RF system is configured for acquiring the imaging magnetic resonance data and calibration magnetic resonance data from the subject, wherein to the method further comprises:

- controlling the magnetic resonance imaging system with the pulse sequence commands to repeatedly acquire the calibration magnetic resonance data from a subject in different motion states, wherein the pulse sequence commands are configured for acquiring the imaging magnetic resonance data according to the parallel imaging magnetic resonance imaging protocol; wherein the pulse sequence commands are further configured for acquiring calibration magnetic resonance data descriptive of GRAPPA kernels of the multiple antenna elements;
- controlling the magnetic resonance imaging system with the pulse sequence commands to acquire the imaging magnetic resonance data; and
- reconstructing multiple GRAPPA kernels from the repeatedly acquired calibration magnetic resonance data.

10. A computer program product comprising machine executable instructions for execution by a processor controlling a magnetic resonance imaging system, wherein execution of the machine executable instructions causes the processor to:

- receive imaging magnetic resonance data descriptive of a region of interest of a subject, wherein the imaging magnetic resonance data is data acquired according to a parallel imaging magnetic resonance imaging protocol;
- receive multiple GRAPPA kernels descriptive of the subject;
- calculate reconstructed k-space data for each one of the multiple GRAPPA kernels using the imaging magnetic resonance data and the one of the multiple GRAPPA kernels;
- assign a residual to each of the multiple GRAPPA kernels by calculating a residual between the reconstructed k-space data and the imaging magnetic resonance data in k-space;
- choose a selected GRAPPA kernel from the set of magnetic resonance images using the residual according to a predefined criteria; and
- reconstruct a selected magnetic resonance image using the selected GRAPPA kernel and the imaging magnetic resonance data.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. 'Computer storage' or 'storage' is a further example of a computer-readable storage medium. Computer storage may be any volatile or non-volatile computer-readable storage medium.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the C programming language or similar programming languages and compiled into machine executable instructions. In some instances the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection maybe made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, bluetooth connection, wireless local area network connection, TCP/IP connection, ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) display, Electroluminescent display (ELD), Plasma display panel (PDP), Liquid crystal display (LCD), Organic light-emitting diode display (OLED), a projector, and Head-mounted display.

Magnetic Resonance (MR) data is defined herein as being the recorded measurements of radio frequency signals emitted by atomic spins using the antenna of a magnetic resonance apparatus during a magnetic resonance imaging scan. Magnetic resonance data is an example of medical imaging data. A Magnetic Resonance (MR) image or magnetic resonance image data is defined herein as being the reconstructed two or three dimensional visualization of anatomic data contained within the magnetic resonance data.

The term "imaging" in imaging magnetic resonance data is a label. Imaging magnetic resonance data is an example of magnetic resonance data.

The term "calibration" in calibration magnetic resonance data is a label. Calibration magnetic resonance data is an example of magnetic resonance data.

The term coil sensitivity data as used herein encompasses a coil sensitivity map or coil sensitivity matrix.

The term quality rating as used herein encompasses a numerical value, a measure, a ranking, and/or a sorting.

BRIEF DESCRIPTION OF THE DRAWINGS

In the following preferred embodiments of the invention will be described, by way of example only, and with reference to the drawings in which:

Fig. 1 illustrates an example of a medical imaging system;
Fig. 2 shows a flow chart which illustrates a method of operating the medical imaging system of Fig. 1;
Fig. 3 illustrates a modification of the medical imaging system of Fig. 1;
Fig. 4 illustrates a further example of a medical imaging system;
Fig. 5 shows a flow chart which illustrates a method of operating the medical imaging system of Fig. 4;
Fig. 6 illustrates a modification of the medical imaging system of Fig. 4;
Fig. 7 illustrates a further example of a medical imaging system;
Fig. 8 shows a flow chart which illustrates a method of operating the medical imaging system of Fig. 7;

and
Fig. 9 illustrates a modification of the medical imaging system of Fig. 7.

DETAILED DESCRIPTION OF THE EMBODIMENTS

Like numbered elements in these figures are either equivalent elements or perform the same function. Elements which have been discussed previously will not necessarily be discussed in later figures if the function is equivalent.

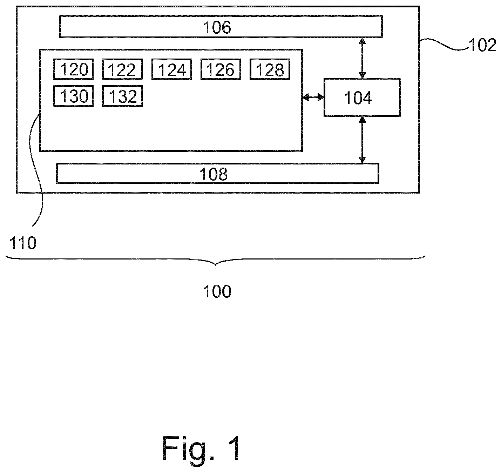

Fig. 1 illustrates an example of a medical imaging system 100. The medical imaging system 100 is shown as comprising a computer 102 with a processor 104. The processor 104 is shown as being in communication with an optional hardware interface 106, a user interface 108, and a memory 110. The hardware interface 106 may for example be used for enabling the processor 104 to exchange data with or control other components of the medical imaging system 100. The hardware interface 106 may also include network elements which enable the processor 104 to exchange data with other or remote storage or data systems. The user interface 108 is also optional and may include such things as a display or display device or components which enable a user to provide data or responses to queries by the processor 104.

The memory is shown as containing machine-executable instructions 120. The machine-executable instructions enable the processor 104 to either control other components and/or to perform image processing and/or mathematical operations. The memory 110 is further shown as containing imaging magnetic resonance data 122 that has been received. It may for example have been received via a network, storage device or even have been acquired by a medical imaging device such as a magnetic resonance imaging system. The memory 110 is further shown as containing multiple sets of coil sensitivity data 124. The computer memory 110 is further shown as containing a set of magnetic resonance images 126. The set of magnetic resonance images 126 was constructed by using each one of the multiple sets of coil sensitivity data to construct a magnetic resonance image using the imaging magnetic resonance data 122.

The memory 110 is further shown as containing a quality rating for each of the set of magnetic resonance images 126. This may for example take different forms in different examples. The quality rating may be such things as a ranking of the images. The quality rating may also be the result of an image processing or other algorithm applied to the magnetic resonance images of the set of magnetic resonance images 126. For example an automatic algorithm may be used to detect fold over or other artifacts within the magnetic resonance image. The memory 110 is further shown as containing a predetermined criteria 130. The predetermined criteria 130 may then be used to use the quality rating 128 to select a selected magnetic resonance image 132. The selected magnetic resonance image 132 may for example be used as a clinical magnetic resonance image or it maybe stored as a result of a magnetic resonance imaging scan. he procedure consists of acquiring a multiplicity of SENSE reference scans, e.g. in a multiplicity of respiratory states. A SENSE scan is acquired; the system tries multiple reconstructions of the SENSE data, each with a different reference scan. For each reconstruction, a residual is calculated, which is an indication of the misfit of data to reference scan. The reconstruction with the lowest residual is presented to the user as the result.

In many Magnetic Resonance (MR) systems, SENSE is used for parallel imaging. This requires the knowledge of coil sensitivity patterns, which are typically acquired by a so-called SENSE reference scan.

If there is some kind of mismatch between reference scan and the actual clinical SENSE scan, artifacts are likely to result. This may be clinically very problematic if the scan cannot be repeated, e.g. because the scan had to be taken at a particular time point relative to a contrast-medium injection, or if the patient obtained stress-stimulation for the imaging procedure. In many cases, the mismatch may be caused by a differing respiration-state between reference scan and SENSE scan. Examples may provide for a mechanism for avoiding artifacts.

In these situations where the acquisition of the SENSE-scan is time-critical and the acquisition of the reference scan is not, we propose to acquire a multiplicity of SENSE reference scans, e.g. in a multiplicity of respiratory states. The system then tries multiple reconstructions of the SENSE data, each reconstruction using a different reference scan. For each reconstruction, a residual is calculated, which is an indication of the misfit of data to reference scan. The reconstruction with the lowest residual is presented to the user as the result.

A note on aforementioned "residual". Leaving out all kinds of normalizations - which are not necessary in this context: if the result of the SENSE scan is defined as $p = (S^H S + R^{-1})^{-1} S^H m$, we define the residual as $r = Sp - m$.. The overall residual over the whole image (or volume) is calculated as a sum of $|r|^2$.

Some examples may acquire reference scans after the actual imaging scan. Such examples may contain the following features in their workflow:

1. Acquire a simple reference scan (typically acquired at free breathing, which comes close to the expiration scan).
2. Acquire the clinical. This scan would, by default, be configured to store its raw data. The patient may be instructed to hold his breath in expiration or left to freely breathe; however, it may be that the patient does not understand, or is unable to hold his breath, or, by mere coincidence, strongly inhales during the most critical part of the clinical scan.
3. If the resulting image quality is fine, the workflow stops here; but if it is not, the operator schedules a series (e.g. 2) of additional reference scans, while instructing the patient on (e.g.) expiration on one and inspiration on another.
4. A delayed reconstruction is requested of the clinical scan; that reconstruction considers all available reference scans and selects the best one.

In another example, the selection of the reference scan may be done per volume, per slice or even per image region.

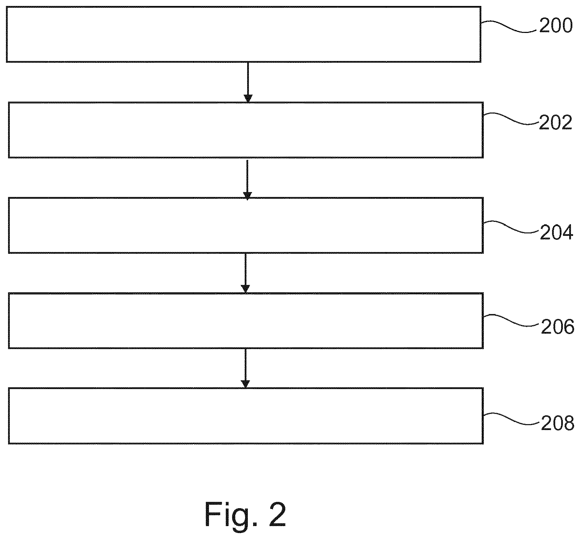

Fig. 2 shows a flowchart which illustrates a method of operating the medical imaging system 100 of Fig. 1. First in step 200 the imaging magnetic resonance data 122 is received. The imaging magnetic resonance data is acquired according to a parallel imaging magnetic resonance imaging protocol. Next in step 202 the multiple sets of coil sensitivity data 124 are also received. Then in step 204 the set of magnetic resonance images 126 is reconstructed using the imaging magnetic resonance data 122 and the multiple sets of coil sensitivity data 124. Next in step 206 a quality rating is assigned to each of the set of magnetic resonance images 126. Finally in step 208 the selected magnetic resonance image 132 is selected from the set of magnetic resonance images 126 using the quality rating 128 and the predetermined criteria 130.

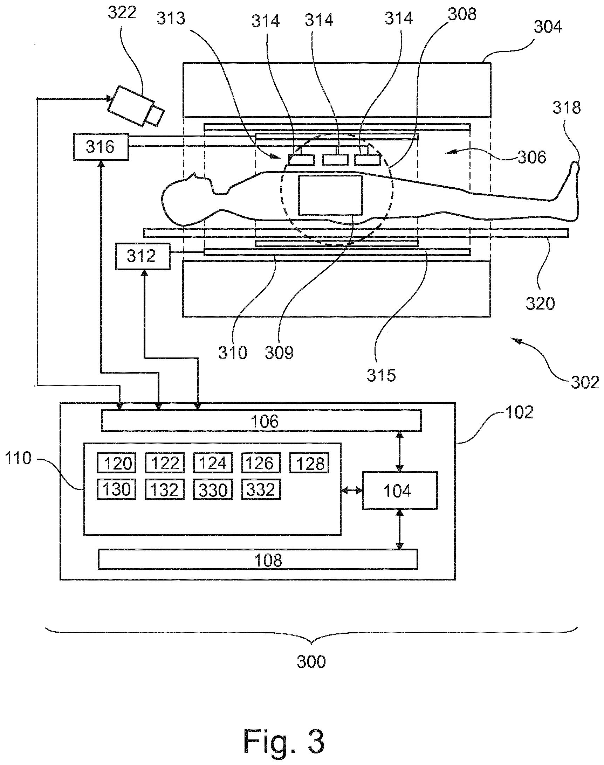

Fig. 3 shows a further example of a medical imaging system 300. The medical imaging system 300 in Fig. 3 is a modification of the medical imaging system 100 in Fig. 1. The medical imaging system 300 further comprises a magnetic resonance imaging system 302.

The magnetic resonance imaging system 302 comprises a main magnet 304, which maybe referred to as the magnet. The magnet 304 is a superconducting cylindrical type magnet 304 with a bore 306 through it. The use of different types of magnets is also possible. Inside the cryostat of the cylindrical magnet, there is a collection of superconducting coils. Within the bore 306 of the cylindrical magnet 304 there is an imaging zone 308 where the magnetic field is strong and uniform enough to perform magnetic resonance imaging.

Within the bore 306 of the magnet there is also a set of magnetic field gradient coils 310 which is used for acquisition of magnetic resonance data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 are multiple coil elements 314 that each function as radio-frequency antennas for manipulating the orientation of magnetic spins within the imaging zone 308 and for receiving radio transmissions from spins also within the imaging zone 308. The radio frequency coils may also be referred to as a radio frequency antennas or as antennas. The multiple coil elements may also be referred to as antenna elements. The radio frequency antennas may also be referred to as channels. The multiple coil elements 314 are connected to a radio frequency transceiver 316. The multiple coil elements 314 and radio frequency transceiver 316 may have separate transmitters and receivers for each the multiple coil elements 314. The coil elements 314 and the transceiver 316 form a radio-frequency system.

The coil elements 314 may be used to acquire magnetic resonance data separately. The coil elements 314 may therefore be used for a parallel imaging magnetic resonance technique. An optional body coil 315 is also shown. The body coil 315 would be useful in the parallel imaging technique as it could take acquired data at the same time as the individual coil elements 314 and be used for calculating a set of coil sensitivities.

The magnetic resonance data may be acquired from within the imaging zone 308. The location of a region of interest 309 is visible within the imaging zone 308.

It can be seen that different coil elements 114 are different distances from different regions of the region of interest 309. Different coil elements 314 will therefore be more or less sensitive to various portions of the imaging zone 309.

Within the bore 306 of the magnet 304 there is a subject support 320 which supports the subject in the the imaging zone 308. Within the imaging zone 308 is visible an imaging coil 313. The imaging coil may also be referred to as a receive coil. The imaging coil 313 comprises multiple antenna elements 314 that may be used for a parallel imaging magnetic resonance protocol.

Also depicted in Fig. 3 is an optional camera 322 that functions as a motion sensor. The camera 322 is intended to be representative and may be replaced for example by a respiratory monitor, a chest expansion belt, the use of a magnetic resonance navigator, an EEG system, fiducial markers either for optical or magnetic resonance imaging systems. In short, the camera 322 is intended to be representative of a general motion sensor for the subject 318.

The transceiver 316, the gradient coil power supply 312 and the optional camera 322 are shown as being connected to the hardware interface 106 of the computer system 102.

The memory 110 shows identical contents with the memory 110 of Fig. 1. The memory 110 is additionally shown as containing pulse sequence commands 330. The pulse sequence commands 330 are configured for enabling the processor 104 to acquire the imaging magnetic resonance data 122 and also additionally calibration magnetic resonance data 332. The pulse sequence commands 330 may be instructions or data which may be converted into such instructions that enable the processor 104 to control the magnetic resonance imaging system 302 to acquire magnetic resonance data. The machine-executable instructions 120 may also be used to calculate the multiple sets of coil sensitivity data 124 from the calibration magnetic resonance data 332. The calibration magnetic resonance data 332 represents calibration magnetic resonance data 332 that has been acquired for multiple time periods. The camera 332 may for example be used to trigger the acquisition of the calibration magnetic resonance data 332.

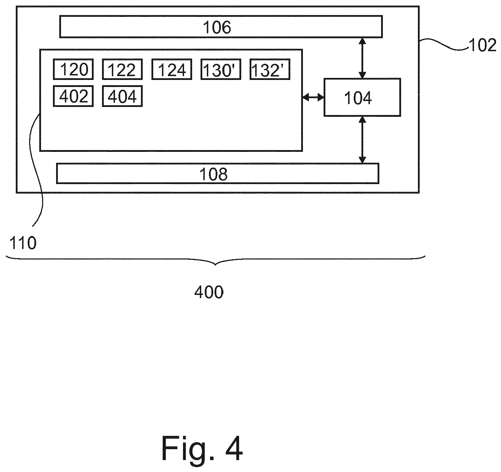

Fig. 4 illustrates a further example of a medical imaging system 400. The medical imaging system 100 is shown as comprising a computer 102 with a processor 104. The processor 104 is shown as being in communication with an optional hardware interface 106, a user interface 108, and a memory 110. The hardware interface 106 may for example be used for enabling the processor 104 to exchange data with or control other components of the medical imaging system 100. The hardware interface 106 may also include network elements which enable the processor 104 to exchange data with other or remote storage or data systems. The user interface 108 is also optional and may include such things as a display or display device or components which enable a user to provide data or responses to queries by the processor 104.

The memory is shown as containing machine-executable instructions 120. The machine-executable instructions enable the processor 104 to either control other components and/or to perform image processing and/or mathematical operations. The memory 110 is further shown as containing imaging magnetic resonance data 122 that has been received. It may for example have been received via a network, storage device or even have been acquired by a medical imaging device such as a magnetic resonance imaging system. The memory 110 is further shown as containing multiple sets of coil sensitivity data 124.

The memory 110 is further shown as containing a quality rating 402 that has been assigned to the multiple sets of coil sensitivity data 124 using the imaging magnetic resonance data 122. The memory 110 is further shown as containing a set of predetermined criteria 130 that is used to evaluate the quality rating 402 and select a selected set of coil sensitivity data 404. The selected set of coil sensitivity data 404 is then used with the imaging magnetic resonance data 122 to reconstruct the selected magnetic resonance image 132'. The selected magnetic resonance image 132' is shown as being stored in the memory 110.

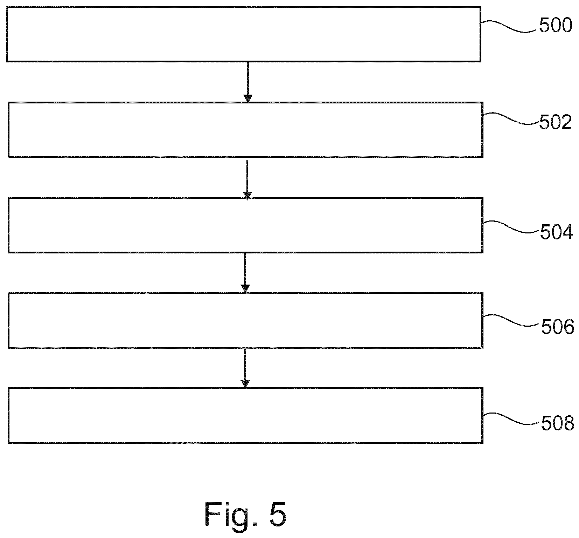

Fig. 5 shows a flowchart which illustrates a method of operating the medical imaging system 400 of Fig. 4. The method in Fig. 5 may for example be implemented by the machine-executable instructions 120. First in step 500 the imaging magnetic resonance data 122 is received. The imaging magnetic resonance data is data acquired according to a parallel imaging magnetic resonance imaging protocol. Next in step 502 the multiple sets of coil sensitivity data 124 are received. Next in step 504 a quality rating 402 is assigned to each of the multiple sets of coil sensitivity data 124 using the imaging magnetic resonance data 122. This for example may be done in either k-space or in image space using various methods. Then in step 506 a selected set of coil sensitivity data 404 is selected using the quality rating 402 for each of the multiple sets of coil sensitivity data 124 according to a predetermined criteria 130'. Finally in step 508, the selected magnetic resonance image 132' is reconstructed using the selected set of coil sensitivity data 404 and the imaging magnetic resonance data 122.

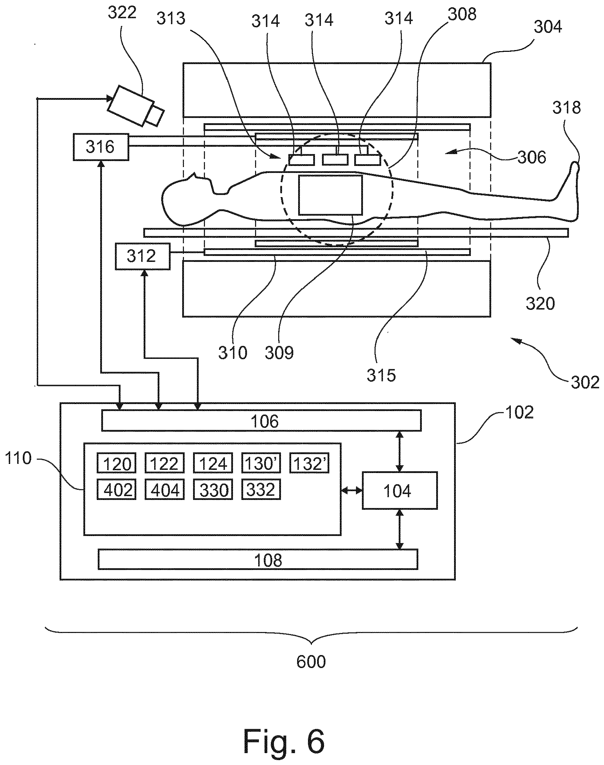

Fig. 6 shows a further example of a medical imaging system 600. The medical imaging system 600 in Fig. 6 is a modification of the medical imaging system 100 in Fig. 4. The medical imaging system 300 further comprises a magnetic resonance imaging system 302.

The magnetic resonance imaging system 302 comprises a main magnet 304, which maybe referred to as the magnet. The magnet 304 is a superconducting cylindrical type magnet 304 with a bore 306 through it. The use of different types of magnets is also possible. Inside the cryostat of the cylindrical magnet, there is a collection of superconducting coils. Within the bore 306 of the cylindrical magnet 304 there is an imaging zone 308 where the magnetic field is strong and uniform enough to perform magnetic resonance imaging.

Within the bore 306 of the magnet there is also a set of magnetic field gradient coils 310 which is used for acquisition of magnetic resonance data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 are multiple coil elements 314 that each function as radio-frequency antennas for manipulating the orientation of magnetic spins within the imaging zone 308 and for receiving radio transmissions from spins also within the imaging zone 308. The radio frequency coils may also be referred to as a radio frequency antennas or as antennas. The multiple coil elements may also be referred to as antenna elements. The radio frequency antennas may also be referred to as channels. The multiple coil elements 314 are connected to a radio frequency transceiver 316. The multiple coil elements 314 and radio frequency transceiver 316 may have separate transmitters and receivers for each the multiple coil elements 314. The coil elements 314 and the transceiver 316 form a radio-frequency system.

The coil elements 314 may be used to acquire magnetic resonance data separately. The coil elements 314 may therefore be used for a parallel imaging magnetic resonance technique. An optional body coil 315 is also shown. The body coil 315 would be useful in the parallel imaging technique as it could take acquired data at the same time as the individual coil elements 314 and be used for calculating a set of coil sensitivities.

The magnetic resonance data may be acquired from within the imaging zone 308. The location of a region of interest 309 is visible within the imaging zone 308.

It can be seen that different coil elements 114 are different distances from different regions of the region of interest 309. Different coil elements 314 will therefore be more or less sensitive to various portions of the imaging zone 309.

Within the bore 306 of the magnet 304 there is a subject support 320 which supports the subject in the the imaging zone 308. Within the imaging zone 308 is visible an imaging coil 313. The imaging coil may also be referred to as a receive coil. The imaging coil 313 comprises multiple antenna elements 314 that may be used for a parallel imaging magnetic resonance protocol.

Also depicted in Fig. 6 is an optional camera 322 that functions as a motion sensor. The camera 322 is intended to be representative and may be replaced for example by a respiratory monitor, a chest expansion belt, the use of a magnetic resonance navigator, an EEG system, fiducial markers either for optical or magnetic resonance imaging systems. In short, the camera 322 is intended to be representative of a general motion sensor for the subject 318.

The transceiver 316, the gradient coil power supply 312 and the optional camera 322 are shown as being connected to the hardware interface 106 of the computer system 102.

The memory 110 shows identical contents with the memory 110 of Fig. 4. The memory 110 is additionally shown as containing pulse sequence commands 330. The pulse sequence commands 330 are configured for enabling the processor 104 to acquire the imaging magnetic resonance data 122 and also additionally calibration magnetic resonance data 332. The pulse sequence commands 330 may be instructions or data which may be converted into such instructions that enable the processor 104 to control the magnetic resonance imaging system 302 to acquire magnetic resonance data. The machine-executable instructions 120 may also be used to calculate the multiple sets of coil sensitivity data 124 from the calibration magnetic resonance data 332. The calibration magnetic resonance data 332 represents calibration magnetic resonance data 332 that has been acquired for multiple time periods. The camera 332 may for example be used to trigger the acquisition of the calibration magnetic resonance data 332.

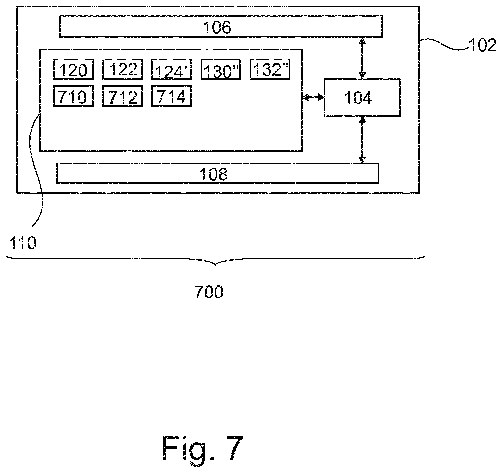

Fig. 7 illustrates a further example of a medical imaging system 700. The medical imaging system 100 is shown as comprising a computer 102 with a processor 104. The processor 104 is shown as being in communication with an optional hardware interface 106, a user interface 108, and a memory 110. The hardware interface 106 may for example be used for enabling the processor 104 to exchange data with or control other components of the medical imaging system 100. The hardware interface 106 may also include network elements which enable the processor 104 to exchange data with other or remote storage or data systems. The user interface 108 is also optional and may include such things as a display or display device or components which enable a user to provide data or responses to queries by the processor 104.

The memory is shown as containing machine-executable instructions 120. The machine-executable instructions enable the processor 104 to either control other components and/or to perform image processing and/or mathematical operations. The memory 110 is further shown as containing imaging magnetic resonance data 122 that has been received. It may for example have been received via a network, storage device or even have been acquired by a medical imaging device such as a magnetic resonance imaging system.

The memory 110 is further shown as containing multiple GRAPPA kernels 124' descriptive of the subject. The multiple GRAPPA kernels 124' may for example represent the subject in a variety or different motion states. The memory 110 is further shown as containing reconstructed k-space 710. The memory is further shown as containing a residual 712 that was calculated between the reconstructed k-space and the imaging magnetic resonance data 122 in k-space. The memory 110 is further shown as containing a selected GRAPPA kernel 714 that was selected using the residuals 712 and a predetermined criteria 130". The memory is further shown as containing a selected magnetic resonance image 132" that was reconstructed using the magnetic resonance imaging data 122 and the selected GRAPPA kernel 714 according to a GRAPPA magnetic resonance imaging protocol.

The example of Fig. 7 extends what was presented in Fig. 1. The extension here is that with a GRAPPA based reconstruction, the GRAPPA kernels can be derived from reference scans or from auto-calibration signals. Both can be corrupted/not-aligned with the clinical scan data.

Based on the multiplicity of reference scans or re-acquisition of auto-calibration signals, a multiplicity of GRAPPA kernels can be derived. The system then tries multiple reconstructions of the clinical data, each reconstruction using a different set of GRAPPA kernels. For each reconstruction, a residual is calculated, which is an indication of the misfit of data to GRAPPA kernels (i.e. the correlations captured in the GRAPPA kernels does not match the true correlations within the data). The reconstruction with the lowest residual is presented to the user as the result.

The GRAPPA operation can be written as:

$$\hat{m}_j(k) = \sum_{q=1}^{N_c} G_{qj} m_q(k + \Delta k)$$

Where $\hat{m}_j(k)$ is the signal for coil element 'j' at location k in k-space which is synthesized/computed, $G_{qj}$ is the matrix created from the GRAPPA kernels containing the correlation between coil 'j' and 'q' ([1 x #kernel size]), and $m_q(k + \Delta k)$ is the vector containing the measured k-space value for coil element 'q' in the neighbourhood of location k in k-space as defined by $\Delta k$ matching the GRAPPA kernel definition.

Once the complete k-space is reconstructed for each channel based on the measure data, the same operation can be used to predict the measured k-space values based on the synthesized data:

$$\hat{m}_j(k_m) = \sum_{q=1}^{N_c} G_{qj} \hat{m}_q(k_m + \Delta k)$$

Where $k_m$ is now the location in k-space which has been measured and hence ($k_m + \Delta k$) map to locations in k-space which have not been measured but synthesized (note: some locations might have been measured).

A "residual" can be computed based on the actual measured data and the predicted data in a similar fashion as described in the text above:

$$r_j(k) = m_j(k) - \hat{m}_j(k)$$

The overall residual over the whole image (or volume) is calculated as a sum of $|r_j(k)|^2$ over all measured k-space locations and all coil elements. (Note that energy in image domain has a 1-1 relation with the energy in k-space (Parseval's Theorem) hence the above definition will be the equivalent of the residual in the SENSE reconstruction case).

The envisioned workflow remains largely the same with a small addition that the 'reference scan' can also be replaced by 'auto-calibration signals'.

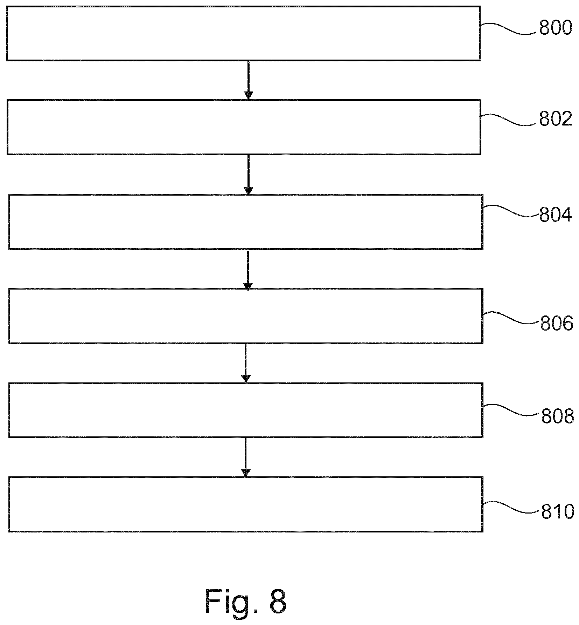

Fig. 8 shows a flowchart which illustrates a method of operating the medical imaging system 700 of Fig. 7. First in step 800 the magnetic resonance imaging data 122 is received. Next in step 802 multiple GRAPPA kernels descriptive of the subject 124' are received. Next in step 804 the reconstructed k-space data 710 is calculated for each of the multiple GRAPPA kernels 124'. Next in step 806 a residual 712 is assigned to each of the multiple GRAPPA kernels 124' by calculating a residual between the reconstructed k-space data 710 and the imaging magnetic resonance data 122 in k-space. Next in step 808 a selected GRAPPA kernel 714 is selected using the residuals 712 and a predetermined criteria 130". Finally in step 810 a selected magnetic resonance image 132" is reconstructed using the selected GRAPPA kernel 714 and the imaging magnetic resonance data 122 according to a GRAPPA magnetic resonance imaging protocol.

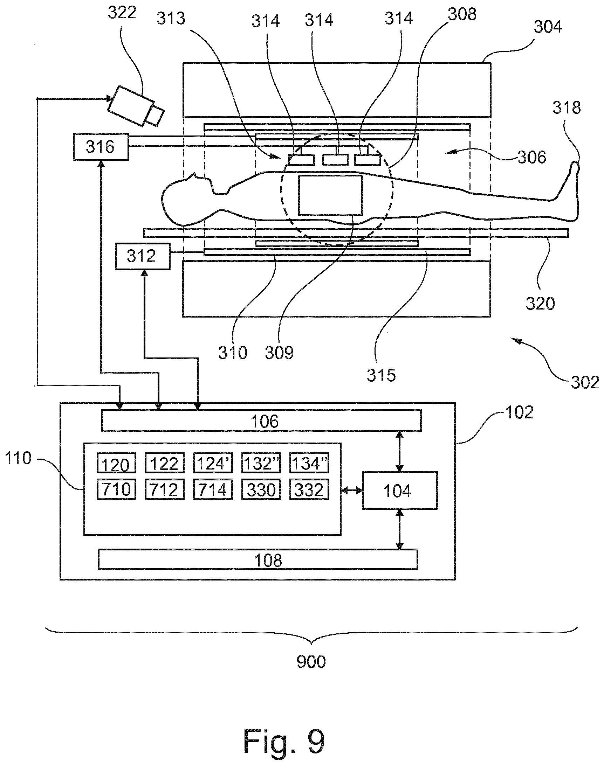

Fig. 9 shows a further example of a medical imaging system 900. The medical imaging system 900 in Fig. 9 is a modification of the medical imaging system 100 in Fig. 7. The medical imaging system 300 further comprises a magnetic resonance imaging system 302.

The magnetic resonance imaging system 302 comprises a main magnet 304, which maybe referred to as the magnet. The magnet 304 is a superconducting cylindrical type magnet 304 with a bore 306 through it. The use of different types of magnets is also possible. Inside the cryostat of the cylindrical magnet, there is a collection of superconducting coils. Within the bore 306 of the cylindrical magnet 304 there is an imaging zone 308 where the magnetic field is strong and uniform enough to perform magnetic resonance imaging.

Within the bore 306 of the magnet there is also a set of magnetic field gradient coils 310 which is used for acquisition of magnetic resonance data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 are multiple coil elements 314 that each function as radio-frequency antennas for manipulating the orientation of magnetic spins within the imaging zone 308 and for receiving radio transmissions from spins also within the imaging zone 308. The radio frequency coils may also be referred to as a radio frequency antennas or as antennas. The multiple coil elements may also be referred to as antenna elements. The radio frequency antennas may also be referred to as channels. The multiple coil elements 314 are connected to a radio frequency transceiver 316. The multiple coil elements 314 and radio frequency transceiver 316 may have separate transmitters and receivers for each the multiple coil elements 314. The coil elements 314 and the transceiver 316 form a radio-frequency system.

The coil elements 314 may be used to acquire magnetic resonance data separately. The coil elements 314 may therefore be used for a parallel imaging magnetic resonance technique. An optional body coil 315 is also shown. The body coil 315 would be useful in the parallel imaging technique as it could take acquired data at the same time as the individual coil elements 314 and be used for calculating a set of coil sensitivities.

The magnetic resonance data may be acquired from within the imaging zone 308. The location of a region of interest 309 is visible within the imaging zone 308.

It can be seen that different coil elements 114 are different distances from different regions of the region of interest 309. Different coil elements 314 will therefore be more or less sensitive to various portions of the imaging zone 309.

Within the bore 306 of the magnet 304 there is a subject support 320 which supports the subject in the the imaging zone 308. Within the imaging zone 308 is visible an imaging coil 313. The imaging coil may also be referred to as a receive coil. The imaging coil 313 comprises multiple antenna elements 314 that may be used for a parallel imaging magnetic resonance protocol.

Also depicted in Fig. 9 is an optional camera 322 that functions as a motion sensor. The camera 322 is intended to be representative and may be replaced for example by a respiratory monitor, a chest expansion belt, the use of a magnetic resonance navigator, an EEG system, fiducial markers either for optical or magnetic resonance imaging systems. In short, the camera 322 is intended to be representative of a general motion sensor for the subject 318.

The transceiver 316, the gradient coil power supply 312 and the optional camera 322 are shown as being connected to the hardware interface 106 of the computer system 102.

The memory 110 shows identical contents with the memory 110 of Fig. 9. The memory 110 is additionally shown as containing pulse sequence commands 330. The pulse sequence commands 330 are configured for enabling the processor 104 to acquire the imaging magnetic resonance data 122 and also additionally calibration magnetic resonance data 332. The pulse sequence commands 330 may be instructions or data which may be converted into such instructions that enable the processor 104 to control the magnetic resonance imaging system 302 to acquire magnetic resonance data. The machine-executable instructions 120 may also be used to calculate the multiple GRAPPA kernels 124' from the calibration magnetic resonance data 332. The calibration magnetic resonance data 332 represents calibration magnetic resonance data 332 that has been acquired for multiple time periods. The camera 332 may for example be used to trigger the acquisition of the calibration magnetic resonance data 332.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

LIST OF REFERENCE NUMERALS

| | |
|---|---|
| 100 | medical imaging system |
| 102 | computer |
| 104 | processor |
| 106 | hardware interface |
| 108 | user interface |
| 110 | memory |
| 120 | machine executable instructions |
| 122 | imaging magnetic resonance data |
| 124 | multiple sets of coil sensitivity data |
| 124' | multiple GRAPPA kernels |
| 126 | set of magnetic resonance images |
| 128 | quality rating for each of 126 |
| 130 | predetermined criteria |
| 130' | predetermined criteria |
| 130" | predetermined criteria |
| 132 | selected magnetic resonance image |
| 132' | selected magnetic resonance image |
| 132" | selected magnetic resonance image |
| 200 | receive imaging magnetic resonance data descriptive of a region of interest of a subject, wherein the imaging magnetic resonance data is data acquired according to a parallel imaging magnetic resonance imaging protocol |
| 202 | receive multiple sets of coil sensitivity data descriptive of the region of interest of the subject |
| 204 | reconstruct a set of magnetic resonance images, wherein each member of the set of magnetic resonance images is created by reconstructing according to the parallel imaging magnetic resonance imaging protocol a magnetic resonance image using the imaging magnetic resonance data and one of the set of multiple coil sensitivity data |
| 206 | assign a quality rating to each of the set of magnetic resonance images, wherein the quality rating is descriptive of image quality |
| 208 | choose a selected magnetic resonance image from the set of magnetic resonance images using the quality rating using a predefined criteria |
| 300 | medical imaging system |
| 302 | magnetic resonance system |
| 304 | main magnet |
| 306 | bore of magnet |
| 308 | imaging zone |
| 309 | region of interest |
| 310 | magnetic field gradient coils |
| 312 | gradient coil power supply |
| 313 | imaging coil (also note as receive coil) |
| 314 | antenna element |
| 315 | body coil |
| 316 | transceiver |
| 318 | subject |
| 320 | subject support |
| 322 | camera |
| 330 | pulse sequence commands |
| 332 | calibration magnetic resonance data |
| 400 | medical imaging system |
| 402 | quality rating of 124 |
| 404 | selected set of coil sensitivity data |
| 500 | receive imaging magnetic resonance data descriptive of a region of interest of a subject |
| 502 | receive multiple sets of coil sensitivity data descriptive of the region of interest of the subject |
| 504 | assigning a quality rating to each of the multiple sets of coil sensitivity data |
| 506 | choose a selected set of coil sensitivity data using the quality rating and a predefined criteria |
| 508 | reconstruct a selected magnetic resonance image using the selected set of coil sensitivity data and the imaging magnetic resonance data and the selected set of coil sensitivity data |
| 600 | medical imaging system |
| 700 | medical imaging system |
| 710 | reconstructed k-space data |
| 712 | residual |
| 714 | selected GRAPPA kernel |
| 800 | receive imaging magnetic resonance data descriptive of a region of interest of a subject |
| 802 | receive multiple GRAPPA kernels descriptive of the subject |
| 804 | calculate reconstructed k-space data for each one of the multiple GRAPPA kernels using the imaging magnetic resonance data and the one of the multiple GRAPPA kernels |
| 806 | assign a residual to each of the multiple GRAPPA kernels by calculating a residual between the reconstructed k-space data and the imaging magnetic resonance data in k-space |
| 808 | choose a selected GRAPPA kernel from the set of magnetic resonance images using the residual according to a a predefined criteria |
| 810 | reconstruct a selected magnetic resonance image using the selected GRAPPA kernel and the imaging magnetic resonance data |
| 900 | medical imaging system |

## Claims

1. A medical imaging system (100, 300), comprising:

    - a memory (110) for storing machine executable instructions; (120) and

- a processor (104) for controlling the medical imaging system, wherein execution of the machine executable instructions causes the processor to:

- receive (200) imaging magnetic resonance data (122) descriptive of a region of interest (309) of a subject (320), wherein the imaging magnetic resonance data is data acquired according to a parallel imaging magnetic resonance imaging protocol;

- receive (202) multiple sets of coil sensitivity data (124) descriptive of the region of interest of the subject;

- reconstruct (204) a set of magnetic resonance images (126), wherein each member of the set of magnetic resonance images is created by reconstructing according to the parallel imaging magnetic resonance imaging protocol a magnetic resonance image using the imaging magnetic resonance data and one of the set of multiple coil sensitivity data;

- assign (206) a quality rating (128) to each of the set of magnetic resonance images, wherein the quality rating is descriptive of image quality; and

- choose (208) a selected magnetic resonance image (132) from the set of magnetic resonance images using the quality rating and a predefined criteria.

2. The medical imaging system of claim 1, wherein the medical imaging system further comprises a magnetic resonance imaging system (302), wherein the magnetic resonance imaging system comprises an RF system comprising an imaging coil (316, 313), wherein the imaging coil comprises multiple antenna elements (314), wherein the RF system is configured for acquiring the imaging magnetic resonance data and calibration magnetic resonance data from the subject, wherein the memory further contains pulse sequence commands (330), wherein the pulse sequence commands are configured for acquiring the imaging magnetic resonance data according to the parallel imaging magnetic resonance imaging protocol; wherein the pulse sequence commands are further configured for acquiring the calibration magnetic resonance data descriptive of coil sensitivities of the multiple antenna elements, wherein execution of the machine executable instructions further cause the processor to:

- control the magnetic resonance imaging system with the pulse sequence commands to repeatedly acquire the calibration magnetic resonance data;

- control the magnetic resonance imaging system with the pulse sequence commands to acquire the imaging magnetic resonance data; and

- reconstruct the multiple sets of coil sensitivity data from the repeatedly acquired calibration magnetic resonance data.

3. The medical imaging system of claim 2, wherein the magnetic resonance imaging system further comprises a motion sensor (322) configured for measuring motion data descriptive of a motion of the subject, wherein execution of the machine executable instructions further causes the processor to trigger repeated acquisition of the calibration magnetic resonance data using the motion data.

4. The medical imaging system of claim 2 or 3, wherein execution of the machine executable instructions further causes the processor to:

- reject the multiple sets of coil sensitivity data if the quality rating of each of the set of magnetic resonance images meets a predetermined criteria;

- control the magnetic resonance imaging system with the pulse sequence commands to acquire replacement calibration magnetic resonance data at least one time;

- reconstruct at least one of the set of replacement coil sensitivity data from the replacement calibration magnetic resonance data; and

- reconstruct the magnetic resonance image according to the parallel imaging magnetic resonance imaging protocol using the imaging magnetic resonance data and a set of replacement coil sensitivity data selected from the at least one set of replacement coil sensitivity data.

5. The medical imaging system of any one of the preceding claims, wherein the quality rating is assigned to each of the set of magnetic resonance images by:

- calculating a sparsity transform of each of set of magnetic resonance images; and

- calculate an entropy value from the sparsity transform of each of the set of magnetic resonance images, wherein the quality rating comprises the entropy value.

6. A medical imaging system (400, 600), comprising:

- a memory (110) for storing machine executable instructions (120); and

- a processor (104) for controlling the medical imaging system, wherein execution of the machine executable instructions causes the processor to:

- receive (500) imaging magnetic resonance data (122) descriptive of a region of interest (309) of a subject (318), wherein the imaging magnetic resonance data is data acquired according to a parallel imaging magnetic resonance imaging protocol;

- receive (502) multiple sets of coil sensitivity data (124) descriptive of the region of interest of the subject;

- assigning (504) a quality rating (128) to each of the multiple sets of coil sensitivity data;

- choose (506) a selected set of coil sensitivity data (404) using the quality rating and a predefined criteria (132');and

- reconstruct (508) a selected magnetic resonance image (132') using the selected set of coil sensitivity data and the imaging magnetic resonance data.

7. The medical imaging system of claim 7, wherein the medical imaging system further comprises a magnetic resonance imaging system (302), wherein the magnetic resonance imaging system comprises an RF system comprising an imaging coil (313), wherein the imaging coil comprises multiple antenna elements (314), wherein the RF system is configured for acquiring the imaging magnetic resonance data and calibration magnetic resonance data (332) from the subject, wherein the memory further contains pulse sequence commands (330), wherein the pulse sequence commands are configured for acquiring the imaging magnetic resonance data according to the parallel imaging magnetic resonance imaging protocol; wherein the pulse sequence commands are further configured for acquiring calibration magnetic resonance data descriptive of coil sensitivities of the multiple antenna elements, wherein execution of the machine executable instructions further cause the processor to:

- control the magnetic resonance imaging system with the pulse sequence commands to repeatedly acquire the calibration magnetic resonance data;

- control the magnetic resonance imaging system with the pulse sequence commands to acquire the imaging magnetic resonance data; and

- reconstruct the multiple sets of coil sensitivity data from the repeatedly acquired calibration magnetic resonance data.

8. The medical imaging system of claim 6 or 7, wherein the magnetic resonance data comprises measured coil data measured by multiple antenna elements, wherein the quality rating is assigned to each of the set of magnetic resonance images by:

- calculating estimated coil data for each of the multiple antenna elements; and

- calculate a residual between the estimated coil data and the measured coil data of each of the multiple antenna elements, wherein the quality rating comprises the residual between the estimated coil data and the measured coil data of each of the multiple antenna elements.

9. The medical imaging system of claim 8, wherein the residual is calculated in k-space or image space.

10. The medical imaging system of any one of claims 6 through 9, wherein execution of the machine executable instructions further causes the processor to:

- store the selected magnetic resonance image in the memory or a database;

- display the selected magnetic resonance image on a display; and

- combinations thereof.

11. A medical imaging system (700, 900), comprising:

- a memory (110) for storing machine executable instructions; and

- a processor (104) for controlling the medical imaging system, wherein execution of the machine executable instructions causes the processor to:

- receive (800) imaging magnetic resonance data (122) descriptive of a region of interest (309) of a subject (318), wherein the imaging magnetic resonance data is data acquired according to a parallel imaging magnetic resonance imaging protocol;

- receive (802) multiple GRAPPA kernels (124') descriptive of the subject;

- calculate (804) reconstructed k-space data (710) for each one of the multiple GRAPPA kernels using the imaging magnetic resonance data and the one of the multiple GRAPPA kernels;

- assign (806) a residual (712) to each of the multiple GRAPPA kernels by calculating a residual between the reconstructed k-space data and the imaging magnetic resonance data in k-space;

- choose (808) a selected GRAPPA kernel (714) from the set of magnetic resonance images using the residual according to a a predefined criteria (130"); and

- reconstruct (810) a selected magnetic resonance image using the selected GRAPPA kernel and the imaging magnetic resonance data.

**12.** The medical imaging system of claim 11, wherein the medical imaging system further comprises a magnetic resonance imaging system, wherein the magnetic resonance imaging system comprises an RF system comprising an imaging coil, wherein the imaging coil comprises multiple antenna elements, wherein the RF system is configured for acquiring the imaging magnetic resonance data and calibration magnetic resonance data from the subject, wherein the memory further contains pulse sequence commands, wherein the pulse sequence commands are configured for acquiring the imaging magnetic resonance data according to the parallel imaging magnetic resonance imaging protocol; wherein the pulse sequence commands are further configured for acquiring calibration magnetic resonance data descriptive GRAPPA kernels of the multiple antenna elements, wherein execution of the machine executable instructions further cause the processor to:

- control the magnetic resonance imaging system with the pulse sequence commands to repeatedly acquire the calibration magnetic resonance data;
- control the magnetic resonance imaging system with the pulse sequence commands to acquire the imaging magnetic resonance data; and
- reconstruct multiple GRAPPA kernels from the repeatedly acquired calibration magnetic resonance data.

**13.** The medical imaging system of claim 2, wherein the magnetic resonance imaging system further comprises a motion sensor configured for measuring motion data descriptive of a motion of the subject, wherein execution of the machine executable instructions further causes the processor to trigger repeated acquisition of the calibration magnetic resonance data using the motion data.

**14.** The medical imaging system of claim 2 or 3, wherein the multiple acquisitions of the calibration magnetic resonance data are performed according to any one of the following:

- at least partially before acquisition of the imaging magnetic resonance data;
- at least partially after acquisition of the imaging magnetic resonance data;
- during acquisition of the imaging magnetic resonance data; and
- combinations thereof.

**15.** The medical imaging system of claim 4, wherein execution of the machine executable instructions further causes the processor to:

- store the selected magnetic resonance image image in the memory or a database;
- display the selected magnetic resonance image on a display; and
- combinations thereof.

Fig. 1

```
┌─────────────────────────────────────────┐
│                                         │───200
└─────────────────────────────────────────┘
                     │
                     ▼
┌─────────────────────────────────────────┐
│                                         │───202
└─────────────────────────────────────────┘
                     │
                     ▼
┌─────────────────────────────────────────┐
│                                         │───204
└─────────────────────────────────────────┘
                     │
                     ▼
┌─────────────────────────────────────────┐
│                                         │───206
└─────────────────────────────────────────┘
                     │
                     ▼
┌─────────────────────────────────────────┐
│                                         │───208
└─────────────────────────────────────────┘
```

# Fig. 2

Fig. 3

Fig. 4

Fig. 5

Fig. 6

| 106 | | | | | | 102 |
| 120 | 122 | 124' | 130" | 132" | | 104 |
| 710 | 712 | 714 | | | | |
| 108 | | | | | | |

110

700

# Fig. 7

Fig. 8

Fig. 9

**EP 3 524 996 A1**

Europäisches
Patentamt
European
Patent Office
Office européen
des brevets

# EUROPEAN SEARCH REPORT

Application Number

EP 18 15 5725

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MERLIN J. FAIR ET AL: "Improved dynamic parallel imaging coil calibration method robust to respiratory motion with application to first-pass contrast-enhanced myocardial perfusion imaging : Improved Coil Calibration in Dynamic MR", MAGNETIC RESONANCE IN MEDICINE., vol. 75, no. 6, 1 June 2016 (2016-06-01), pages 2315-2323, XP055505342, US ISSN: 0740-3194, DOI: 10.1002/mrm.25819 | 1,2, 6-10,14 | INV. G01R33/565 G01R33/561 |
| Y | * Section "Methods", in particular subsection "MFP Method", first paragraph on page 2323; figure 1 * | 3,4,13, 15 | |
| | ----- | | |
| X | WO 03/001227 A2 (KONINKL PHILIPS ELECTRONICS NV [NL]; PHILIPS MED SYST INC [US]) 3 January 2003 (2003-01-03) | 1,2,5-7, 10,14 | |
| Y | * page 7, lines 15-30,* page 9, lines 7-28,* page 10, lines 30-31,* page 11,* page 12, lines 1-22 * | 3,4,13, 15 | TECHNICAL FIELDS SEARCHED (IPC) G01R |
| | ----- | | |
| | -/-- | | |

The present search report has been drawn up for all claims

| Place of search | Date of completion of the search | Examiner |
|---|---|---|
| Munich | 11 September 2018 | Lebar, Andrija |

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ROGER NANA ET AL: "Data consistency criterion for selecting parameters for k-space-based reconstruction in parallel imaging", MAGNETIC RESONANCE IMAGING, vol. 28, no. 1, 1 January 2010 (2010-01-01), pages 119-128, XP055505718, TARRYTOWN, NY, US ISSN: 0730-725X, DOI: 10.1016/j.mri.2009.05.047 * Section "Theory", sub-sections "Application to GRAPPA" in Sections "Methods" and "Results"; figures 3a, 4d * | 11,12 | |
| Y | WO 2015/082236 A1 (KONINKL PHILIPS NV [NL]) 11 June 2015 (2015-06-11) * lines 16-26 on page 2, lines 6-11 on page 4, lines 9-13 on page 5, from page 13 line 26 to page 16 line 11; figure 2 * | 3,4,13, 15 | |

TECHNICAL FIELDS
SEARCHED (IPC)

The present search report has been drawn up for all claims

| Place of search | Date of completion of the search | Examiner |
|---|---|---|
| Munich | 11 September 2018 | Lebar, Andrija |

EPO FORM 1503 03.82 (P04C01)

## ANNEX TO THE EUROPEAN SEARCH REPORT
## ON EUROPEAN PATENT APPLICATION NO.

EP 18 15 5725

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2018

| Patent document cited in search report | | Publication date | Patent family member(s) | | Publication date |
|---|---|---|---|---|---|
| WO 03001227 | A2 | 03-01-2003 | GB<br>JP<br>US<br>WO | 2374673 A<br>2004531335 A<br>2003025499 A1<br>03001227 A2 | 23-10-2002<br>14-10-2004<br>06-02-2003<br>03-01-2003 |
| WO 2015082236 | A1 | 11-06-2015 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160003928 A1